Europäisches Patentamt

European Patent Office

Office européen des brevets

(11) Publication number: **0 352 737**
**A2**

## (12) EUROPEAN PATENT APPLICATION

(21) Application number: 89113696.2

(51) Int. Cl.⁴: **H01L 21/225**

(22) Date of filing: 25.07.89

(30) Priority: 27.07.88 US 224648

(43) Date of publication of application:
31.01.90 Bulletin 90/05

(84) Designated Contracting States:
DE FR GB NL

(71) Applicant: **Siemens Aktiengesellschaft**
**Wittelsbacherplatz 2**
**D-8000 München 2(DE)**

(72) Inventor: **Shieh, Chan-Long**
**24 Linden Lane S.**
**Plainsboro NJ 08536(US)**
Inventor: **Kohn, Erhard**
**6 State Park Drive**
**Titusville, NJ 08560(US)**

(54) Method for maskless diffusion.

(57) A method for selectively diffusing silicon into a selected portion of a gallium arsenide substrate comprises exposing a non-selected surface portion to an argon ion plasma, thereafter applying silicon to the surface of the substrate and subjecting it to heat treatment so as to promote silicon diffusion.

**FIG. 1A**

**FIG. 1B**

**FIG. 1C**

EP 0 352 737 A2

## METHOD FOR MASKLESS DIFFUSION

The present invention relates to a method for fabricating semiconductor optoelectric devices and more particularly to a method for selectively diffusing a dopant into a compound semiconductor in the fabrication of a semiconductor laser.

Semiconductor lasers incorporating a heterojunction in the laser structure generally exhibit improved performance over that of a homojunction laser. The heterojunction laser tends to exhibit improved carrier confinement and, in addition, better confinement of the optical field due to the refractive index difference at the heterojunction. The background to the construction and operation of such lasers is described in greater detail in, for example, Chapter 11 of the book "Gallium Arsenide Technology", David K. Ferry; 1985, Howard W. Sams and Co., Inc., Indianapolis, Indiana. Typically, in such a laser, the device performance is improved by employing a stripe geometry to define the current path. A stripe geometry is generally advantageous over a broad-area laser in that it tends to exhibit lower threshold current and a smaller beam size, among other advantages.

Various techniques have been employed in the past to produce stripe geometry lasers. A variety of such methods are disclosed on pages 425-430 of the above-mentioned book "Gallium Arsenide Technology". These include an oxide-defined strip; the use of proton bombardment to form a highly resistive area outside the strip, and a number of other methods directed to a similar end. The methods produce somewhat different results and differ in their degree of processing complexity. Impurity doping into the semiconductor is thus an important area of technology in the fabrication of such lasers.

The diffusion of silicon into AlGaAs/GaAs has found much application in the impurity disordering of AlGaAs/GaAs superlattices for the fabrication of buried heterojunction lasers. See, for example, the article entitled "Stripe-geometry AlGaAs-GaAs quantum-well heterostructure lasers defined by impurity-induced layer disordering", by K. Meehan, J.M. Brown, N. Holonyak, Jr., R.D. Burnham, T.L. Paoli, and W. Streifer in Appl. Phys. Lett., Vol. 44, No. 7; 1 April 1984, pp. 700-702. The article discloses stripe-geometry AlGaAs-GaAs single quantum well heterostructure lasers. The diffusion of silicon into GaAs is known to require the presence of gallium vacancies. See, for example, the article entitled "Diffusion and electrical properties of silicon-doped gallium arsenide", by Mark E. Greiner and James F. Gibbons in J. Appl. Phys. 57(12), 15 June 1985; pp. 5181-5187. The vacancies have been created by using a silicon-dioxide overlayer, see for example, the article entitled "Diffusion of silicon in gallium arsenide using rapid thermal processing: Experiment and model" by Mark E. Greiner and James F. Gibbons in Appl. Phys. Lett. 4A(8) 15 April 1984; pp. 750-752, or by arsenic overpressure, see for example "Closed-Tube Diffusion of Silicon in GaAs From Sputtered Silicon Film" by E. Omura, X.S. Wu, G.A. Vawter, L. Coldren, E. Hu, and J.L. Merz in Electronics Letters; 24 April 1986, Vol. 22, No. 9; pp. 496-497.

For many device applications diffusion must be selective. While ion beam implantation, for example, may conceivably be utilized to achieve such selective impurity doping, it is herein recognized that undesirable characteristics are associated therewith. Beam formation with silicon is not straightforward and the presence of different ions being deflected differently will tend to result in poor pattern definition. Oxide masking requires a number of processing steps and tends to affect the underlying material.

In accordance with an aspect of the invention, a method for selectively diffusing silicon into a body of gallium arsenide, comprises the steps of exposing a selected part of a surface area of the body to ionic bombardment; applying a source of silicon to the surface area; and treating the body so as to promote silicon diffusion therein.

In accordance with another aspect of the invention, a method for selectively diffusing silicon into a selected part of a surface of a body of gallium arsenide, comprises the steps of exposing only a non-selected part of the surface of the body to ionic bombardment for selectively removing arsenic therefrom; applying a source of silicon to the surface area; and subjecting the body to heat treatment for promoting entry of silicon therein.

In accordance with a further aspect of the invention, the step of exposing the non-selected part of the surface of the body to ionic bombardment is performed by exposing the non-selected part to an argon plasma.

In accordance with still a further aspect of the invention, the exposing of the non-selected parts to the argon plasma is performed so as to result in the non-selected part exhibiting a surplus of gallium.

In accordance with yet a further aspect of the invention, the step of exposing the non-selected part of the surface of the body to ionic bombardment comprises applying a photoresist layer over the selected part of the surface while not applying the photoresist layer to the non-selected part of said surface; subjecting the selected and non-selected parts of the surface to the ionic bombardment, such that the non-selected part is exposed thereto and the selected part is effectively shielded therefrom by the photoresist layer; removing the photoresist layer; and applying a source of silicon to said surface.

In accordance with still another aspect of the invention, the step of exposing the non-selected parts of the surface of the body to ionic bombardment comprises confining a beam of ions so as to impinge only upon the non-selected parts and so as to leave the selected part of the surface substantially unexposed to ionic bombardment.

In accordance with still yet another aspect of the invention, the step of applying a source of silicon to said surface area comprises applying a layer of silicon to the surface area; and applying a layer of silicon dioxide over the layer of silicon.

In accordance with another further aspect of the invention, the step of applying a source of silicon to the surface area comprises applying a layer of silicon to the surface area, in the presence of arsenic.

In accordance with still another further aspect of the invention, the layer of silicon contains arsenic.

In accordance with another aspect of the invention, the selected part of the surface is selected so as to form a pattern for a semiconductor device.

In accordance with another aspect of the invention, the semiconductor device is a laser.

These and other aspects of the present invention will next be explained in greater detail with the aid of the Drawing, in which

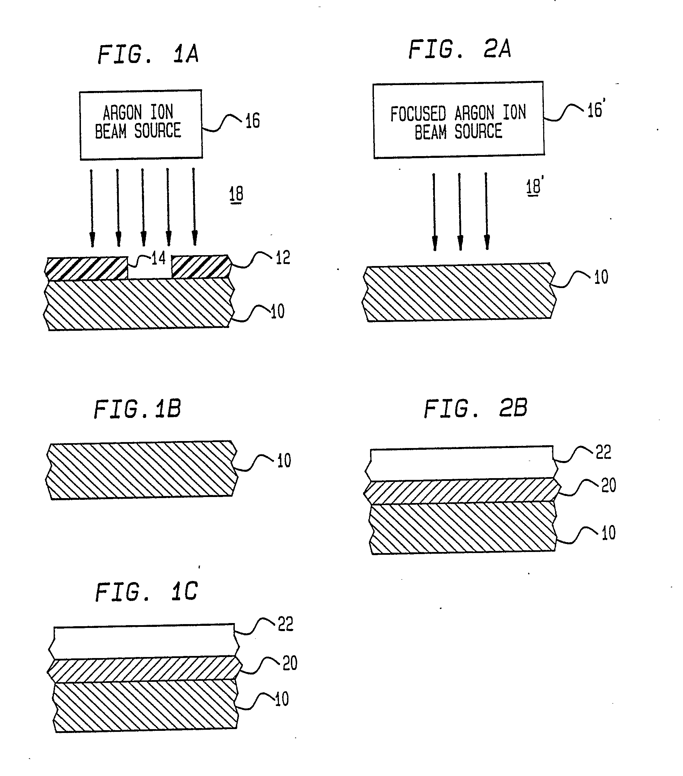

Figures 1 through 4 show respective embodiments of the invention in diagramatic fashion and not to scale.

In the embodiment of Figure 1, 10 is a semi-insulating body or substrate of gallium arsenide, shown in cross-section. Substrate 10 is coated with a layer of photoresist 12 having a hole 14 therein. An argon ion beam source 16 provides an argon plasma generally indicated in Figure 1 as 18. Argon ion plasma 18 causes sputter etching of that portion of substrate 10 exposed to it by hole 14 in photoresist layer 12. Portions of substrate 10 which are covered by an intact layer of photoresist 12 are shielded from sputter etching by plasma 18. Such sputter etching can be readily carried out, for example, in a Perkin Elmer 2400 Sputtering System. After sputtering, photoresist layer 12 is removed as is indicated in Figure 1B. Thereafter, as is shown in Figure 1C, a layer of silicon 20 is formed over substrate 10 and silicon layer 20 is in turn covered by a silicon dioxide layer 22. The sample is then heat treated, typically for several hours and thereafter silicon dioxide layer 22 and silicon layer 20 are removed. The present inventors have found that diffusion of silicon into substrate 10 occurs almost exclusively in the areas which were shielded by photoresist layer 12 and that practically no diffusion of silicon into substrate 10 occurs in the region subject to the sputter etch. Accordingly, selective silicon diffusion into gallium arsenide is achieved by selective modification of the gallium arsenide surface using ion bombardment. The areas where silicon diffusion into gallium arsenide is intended to occur need only be protected by a layer of photoresist 12. The need for oxide masking and the like which can have deleterious effects on the existing semiconductor structure is thereby obviated.

The theory underlying the effectiveness of the method in accordance with the invention is believed to be as follows. The mechanism of silicon diffusion into gallium arsenide has been studied in the 1985 article by Greiner et al., mentioned above, and therein it is disclosed that the diffusion of silicon occurs in pairs. Accordingly, a gallium vacancy is required for diffusion of silicon into gallium arsenide. Two techniques which have been used to create gallium vacancies to facilitate diffusion of silicon into gallium arsenide are the employment of a silicon dioxide layer over a silicon layer and arsenic over-pressure, as discussed in the 1984 article by Greiner et al. and in the article by Omura et al., both mentioned above. It is known in the prior art that sputtering by argon creates a surface rich in gallium by the preferential removal of arsenic; see for example the article entitled "Chemical Preparation of GaAs Surfaces and Their Characterization by Auger Electron and X-Ray Photo Emission Spectroscopies" by Chang, C.C., Citrin, P.H., and Schwartz, B., J. Vac Sci Techo.; 1977, 14, pp. 943-952. The present inventors have herein recognized that a gallium-rich surface will tend to negative the production of gallium vacancies and that accordingly diffusion of silicon into such gallium-rich areas will tend to be prevented. On the other hand, areas not subjected to argon sputtering or, alternatively, areas protected against argon sputtering will not be rich in gallium and accordingly the generation of gallium vacancies will not be inhibited thereby and diffusion of silicon into such areas will be possible.

In the embodiment of Figure 2, no photoresist layer is utilized to shield areas not to be sputtered. Rather, a focused argon ion beam source 16′ is utilized to provide a confined beam 18′ so as to sputter etch a selected area on substrate 10 while leaving other areas substantially unaffected. Thereafter, the method is essentially the same as the method of Figure 1, except that there is no photoresist layer to be removed.

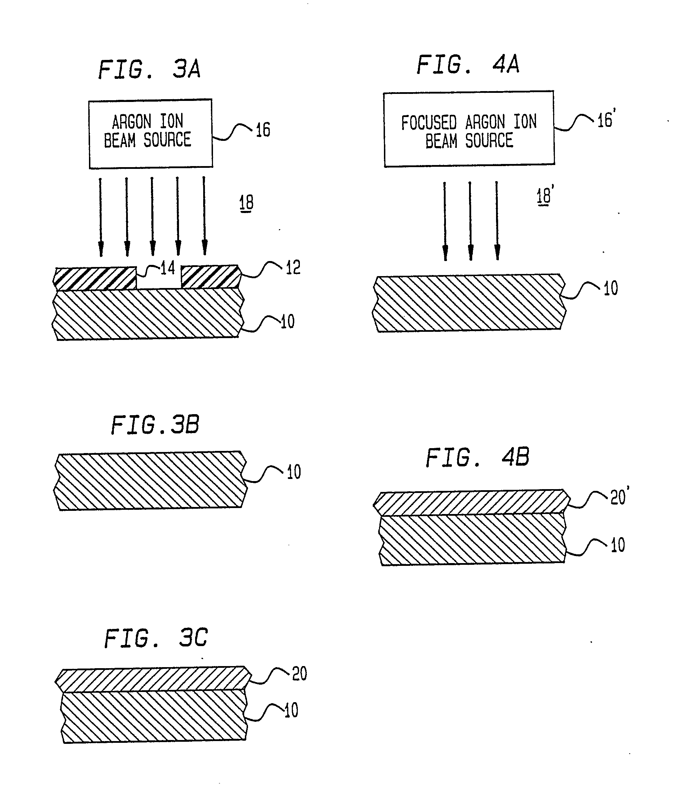

In the embodiment of Figure 3, the steps of Figure 3A and Figure 3B are the same as those followed in Figure 1A and Figure 1B, respectively. However in the step of Figure 3C, no silicon dioxide layer is utilized as was done in the step of Figure 1C. Instead, arsenic is applied, either in the form of a surrounding gas under pressure, for example, one atmosphere, or in the form of arsenic doping of silicon layer 20. With appropriate heat treatment, silicon diffuses into those portions which were shielded from the argon ion sputter or bombardment. In the embodiment of Figure 4, the step of Figure 4A is the same as that in Figure 2A. However, the step in Figure 4B does not utilize silicon dioxide in the manner of Figure 2B but rather employs arsenic in the manner discussed in reference to the step of Figure 3C so as to bring about the diffusion of silicon into substrate 10.

While the present invention has been discussed in terms of exemplary emobdiments, there are modifications possible that will be apparent to one skilled in the art, by which the method of the invention may be modified without departing materially from the scope of the invention as defined by the claims following.

## Claims

1. A method for selectively diffusing silicon into a selected part of a surface of a body of gallium arsenide, comprising the steps of:

(a) exposing a non-selected part of said surface of said body to ionic bombardment for selectively removing arsenic therefrom;

(b) applying a source of silicon to said surface; and

(c) subjecting said body to heat treatment for promoting entry of silicon therein.

2. A method according to Claim 1 wherein said step of exposing said non-selected part of said surface of said body to ionic bombardment is performed by exposing said non-selected part to an argon plasma.

3. A method according to Claim 2 wherein said exposing of said non-selected part to said argon plasma is performed so as to result in said non-selected part exhibiting a surplus of gallium.

4. A method according to Claim 3 wherein said step of exposing said non-selected part of said surface of said body to ionic bombardment comprises

(1) applying a photoresist layer over said selected part of said surface while not applying said photoresist layer to said non-selected part of said surface;

(2) subjecting said selected and non-selected parts of said surface to said ionic bombardment, such that said non-selected part is exposed thereto and said selected part is effectively shielded therefrom by said photoresist layer;

(3) removing said photoresist layer;

(4) applying a source of silicon to said surface; and

(5) heat treating said body of gallium arsenide to promote diffusion of silicon into said body.

5. A method according to Claim 3 wherein said step of exposing said non-selected part of said surface of said body to ionic bombardment comprises confining a beam of ions so as to impinge only upon said non-selected part and so as to leave said selected part of said surface substantially unexposed to ionic bombardment.

6. A method according to Claim 1 wherein said step of applying a source of silicon to said surface area comprises

(1) applying a layer of silicon to said surface area; and

(2) applying a layer of silicon dioxide over said layer of silicon.

7. A method according to Claim 1 wherein said step of applying a source of silicon to said surface area comprises applying a layer of silicon to said surface area.

8. A method according to Claim 7 wherein said step of heat treating comprises applying arsenic vapor to said body of gallium arsenide.

9. A method according to Claim 8 wherein said arsenic vapor is applied under pressure.

10. A method according to Claim 7 wherein said layer of silicon contains arsenic.

11. A method according to Claim 1 wherein said selected part of said surface is selected so as to form a pattern for a semiconductor device.

12. A method according to Claim 8 wherein said selected part of said surface is selected so as to form a pattern for a semiconductor device.

13. A method according to Claim 11 wherein said semiconductor device is a laser.

14. A method according to Claim 12 wherein said semiconductor device is a laser.

15. A method for selectively diffusing silicon into a first portion of a gallium arsenide substrate comprising the steps of:

(a) exposing a second portion of said substrate to an argon ion plasma;

(b) applying a source of silicon to said substrate; and

(c) heat treating said substrate.

16. A method for doping silicon into a surface area of a gallium arsenide body so as to form first and second regions therein, said first region being doped with silicon and said second region being substantially undoped with silicon, comprising:

(a) applying a photoresist layer over said first region;

(b) subjecting said surface area of said gallium arsenide body to an argon plasma so as to

4

selectively remove arsenic from said second region such that an excess of gallium remains therein, said first region being substantially shielded from said argon plasma by said photoresist layer;

(c) removing said photoresist layer;

(d) applying a layer of silicon to said surface area of said gallium arsenide body;

(e) applying a layer of silicon dioxide to said layer of silicon; and

(f) thermally processing said gallium arsenide body so as to create gallium vacancies in said first region and bring about migration of silicon therein.

17. A method for doping silicon into a surface area of a gallium arsenide body so as to form first and second regions therein, said first region being doped with silicon and said second region being substantially undoped with silicon, comprising:

(a) applying a photoresist layer over said first region;

(b) subjecting said surface area of said gallium arsenide body to an argon plasma so as to selectively remove arsenic from said second region such that an excess of gallium remains therein, said first region being substantially shielded from said argon plasma by said photoresist layer;

(c) removing said photoresist layer;

(d) applying a layer of silicon to said surface area of said gallium arsenide body; and

(f) thermally processing said gallium arsenide body in an arsenic vapor atmosphere so as to create gallium vacancies in said first region and bring about migration of silicon therein.

18. A method for doping silicon into a surface area of a gallium arsenide body so as to form first and second regions therein, said first region being doped with silicon and said second region being substantially undoped with silicon, comprising:

(a) applying a photoresist layer over said first region;

(b) subjecting said surface area of said gallium arsenide body to an argon plasma so as to selectively remove arsenic from said second region such that an excess of gallium remains therein, said first region being substantially shielded from said argon plasma by said photoresist layer;

(c) removing said photoresist layer;

(d) applying a layer of silicon doped by arsenic to said surface area of said gallium arsenide body; and

(f) thermally processing said gallium arsenide body so as to create gallium vacancies in said first region and bring about migration of silicon therein.

19. A method for doping silicon into a surface area of a gallium arsenide body so as to form first and second region therein, said first region being doped with silicon and said second region being substantially undoped with silicon, comprising:

(a) directing a focused argon plasma at said second region and so as to substantially avoid said first region, so as to selectively remove arsenic from said second region such that an excess of gallium remains therein;

(b) applying a layer of silicon to said surface area of said gallium arsenide body; and

(c) thermally processing said gallium arsenide body in an atmosphere of arsenic vapor so as to create gallium vacancies in said first region and bring about migration of silicon therein.

20. A method for doping silicon into a surface area of a gallium arsenide body so as to form first and second region therein, said first region being doped with silicon and said second region being substantially undoped with silicon, comprising:

(a) directing a focused argon plasma at said second region and so as to substantially avoid said first region, so as to selectively remove arsenic from said second region such that an excess of gallium remains therein;

(b) applying a layer of silicon doped by arsenic to said surface area of said gallium arsenide body; and

(c) thermally processing said gallium arsenide body so as to create gallium vacancies in said first region and bring about migration of silicon therein.

21. A method for doping silicon into a surface area of a gallium arsenide body so as to form first and second region therein, said first region being doped with silicon and said second region being substantially undoped with silicon, comprising:

(a) directing a focused argon plasma at said second region and so as to substantially avoid said first region, so as to selectively remove arsenic from said second region such that an excess of gallium remains therein;

(b) applying a layer of silicon to said surface area of said gallium arsenide body;

(c) applying a layer of silicon dioxide to said layer of silicon; and

(d) thermally processing said gallium arsenide body so as to create gallium vacancies in said first region and bring about migration of silicon therein.

22. A semiconductor device comprising a gallium arsenide body having a junction formed by doping silicon into a surface area thereof so as to form first and second regions of said junction, said first region being doped with silicon and said second region being substantially undoped with silicon, said semiconductor device being made by the process of:

(a) exposing said second region to ionic bombardment for removing arsenic therefrom;

(b) applying a source of silicon to said surface area; and

(c) subjecting said body to heat treatment for promoting entry of silicon therein.

FIG. 1A

ARGON ION
BEAM SOURCE ～16

18

14 ～12

10

FIG. 2A

FOCUSED ARGON ION
BEAM SOURCE ～16'

18'

10

FIG.1B

10

FIG. 2B

22

20

10

FIG. 1C

22

20

10

## FIG. 3A

ARGON ION BEAM SOURCE ~16

18

~14 ~12

~10

## FIG. 4A

FOCUSED ARGON ION BEAM SOURCE ~16'

18'

~10

## FIG. 3B

~10

## FIG. 4B

~20'

~10

## FIG. 3C

~20

~10